# FASCICULE DE BREVET EUROPEEN

(11) **EP 0 321 366 B1**
(45) Date de publication et mention de la délivrance du brevet: **10.11.1993**
(21) Numéro de dépôt: 88420417.3
(22) Date de dépôt: 14.12.1988
(51) Int. Cl.: H01L 21/76, H01L 21/82

(54) **Procédé de fabrication d'un circuit integre comprenant des transistors MOS moyenne tension**
Verfahren zum Herstellen einer integrierten Schaltung mit MOS-Transistoren mittlerer Spannung
Method of producing an integrated circuit with medium voltage MOS transistors

(30) Priorité: 14.12.1987 FR 8717782
(43) Date de publication de la demande: 21.06.1989
(73) Titulaire: SGS-THOMSON MICROELECTRONICS S.A., 94250 Gentilly (FR)
(72) Inventeur: Boivin, Philippe, F-13770 Venelles (FR)
(74) Mandataire: de Beaumont, Michel

(56) Documents cités:
- GB-A- 2 123 605
- US-A- 4 577 394
- IBM TECHNICAL DISCLOSURE BULLETIN, vol. 27, no. 8, janvier 1985, pages 4720-4721, IBM Corp., New York, US; K.M. ABRAHAMOVICH et al.: "Method for decreasing the capacitance of diffusions formed under recessed-oxide isolation"
- IBM TECHNICAL DISCLOSURE BULLETIN, vol. 27, no. 6, novembre 1984, pages 3245-3246, IBM Corp., New York, US; M.J. WARREN: "Field-implant spacer for isolation devices"
- IBM TECHNICAL DISCLOSURE BULLETIN, vol. 25, no. 7A, décembre 1982, pages 3498-3499, IBM Corp., New York, US; P.E. BAKEMAN et al.: "Recessed oxide isolation with offset field doping"

## Description

La présente invention concerne le domaine des circuits intégrés et plus particulièrement des circuits intégrés comprenant des transistors MOS moyenne tension, c'est-à-dire des transistors MOS sur les drains desquels peuvent être appliquées des tensions de l'ordre de 25 à 50 volts.

Les figures 1, 2A à 2D et 3A, 3B illustrent divers aspects d'un transistor MOS basse tension classique.

La figure 1 représente une vue de dessus d'un tel transistor MOS. Ce transistor comprend une zone de drain 1 munie d'un contact de drain 2, une zone de canal 3 revêtue d'une grille conductrice 4 disposée sur un isolant et une zone de source 5 munie d'un contact de source 6.

Les figures 2A à 2D sont des vues en coupe selon la ligne A-A de la figure 1 de quelques unes des étapes de fabrication d'un transistor MOS tel que celui de la figure 1.

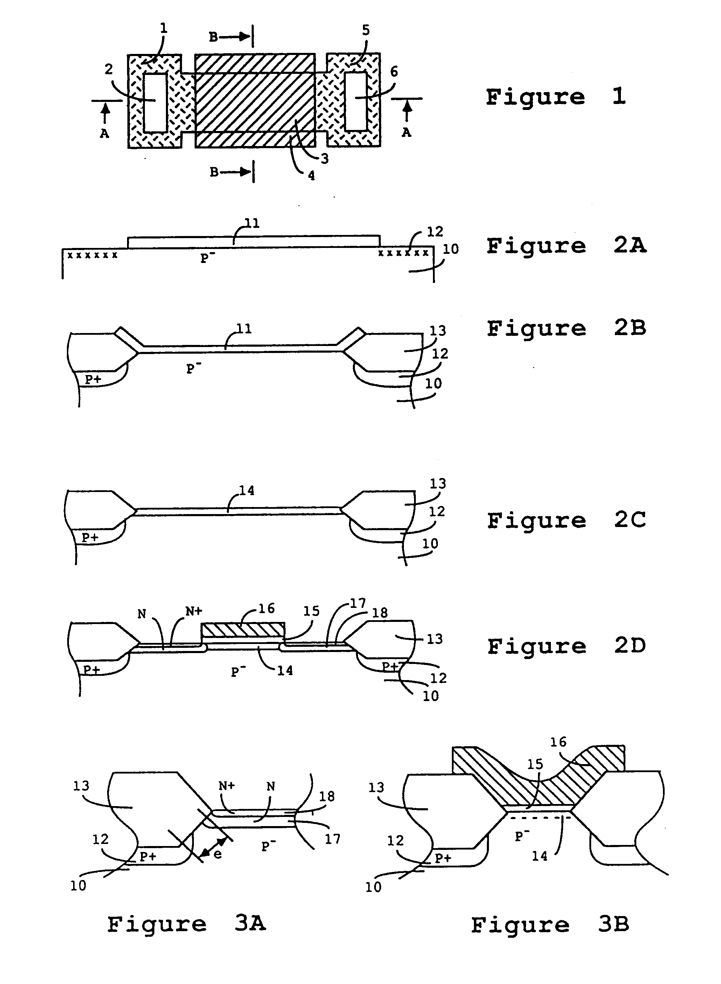

Dans l'étape de la figure 2A, on forme sur un substrat semiconducteur 10 un masque anti-oxydation 11, couramment un masque comprenant une couche mince d'oxyde de silicium (SiO₂) revêtue de nitrure de silicium (dans la suite de la description, on parlera simplement d'une couche d'oxyde et d'une couche de nitrure). Ce masque 11 est utilisé pour délimiter une implantation du même type de conductivité que le substrat, pour former ce que l'on appelle l'implantation de champ ou d'isolement. On obtient ainsi une zone implantée 12, par exemple de type P dans un substrat P⁻.

A l'étape suivante, illustrée en figure 2B, on procède à une oxydation thermique pour former des zones d'oxyde de champ 13. Comme cela est connu, ces zones d'oxyde de champ se développent selon une forme dite en bec d'oiseau représentée pour souci de simplification dans la figure par une pointe triangulaire qui soulève les bords de la couche de nitrure. Pendant cette étape de croissance thermique de l'oxyde 13, les dopants implantés à l'étape précédente diffusent sous l'oxyde de champ pour former la zone dite d'implantation de champ 12 destinée à contribuer à un meilleur isolement entre transistors adjacents.

A l'étape suivante illustrée en figure 2C, on élimine la couche de nitrure 11 et l'on forme à la surface du substrat 10 dans les ouvertures entre les zones d'oxyde de champ une implantation 14 dite implantation de canal dont le rôle sera exposé ultérieurement.

La figure 2D représente une étape ultérieure de fabrication, après réalisation de nombreuses étapes intermédiaires. On retrouve dans cette figure le substrat 10 de type P⁻, la zone d'implantation de champ 12 de type P et l'oxyde de champ 13. Il a été formé et délimité une grille isolée comprenant une couche mince d'oxyde 15 revêtue d'une couche conductrice 16 correspondant à la grille 4 de la figure 1. La couche conductrice de grille peut classiquement être constituée d'aluminium, de silicium polycristallin dopé, d'une combinaison de silicium polycristallin et d'un siliciure de métal réfractaire, etc. En se servant comme masque de la couche d'oxyde de champ 13 et de la grille 16, on procède alors au dopage des régions de source et de drain. Couramment, ceci est réalisé par implantation successive de dopants de type N (type opposé à celui du substrat) par exemple une première implantation d'arsenic et de phosphore, ou de phosphore seul, permettant d'obtenir après recuit une zone diffusée 17 et une deuxième implantation, par exemple d'arsenic permettant d'obtenir une zone surdopée en surface 18. C'est sur ces zones 18 de drain et de source que sont formés les contacts de drain et de source 2 et 6 illustrés en figure 1. Ces contacts ne sont pas représentés dans la vue en coupe de la figure 2D.

La figure 3A représente une vue agrandie quoique toujours schématique de la limite entre le bec d'oiseau de l'oxyde de champ et une partie de la zone de drain. Dans une technologie classique de MOS basse tension, l'épaisseur de la couche d' oxyde de champ est de l'ordre de 0,8 à 1,5 micromètre, la profondeur de diffusion de la couche d'implantation de champ 12 est de l'ordre de 0,5 micromètre, c'est-à-dire qu'elle va se déplacer latéralement également sur une longueur de l'ordre de 0,5 micromètre vers la pointe du bec d'oiseau. La profondeur de diffusion de la couche 17 est de l'ordre de 0,5 à 0,8 micromètre et la profondeur de diffusion de la couche 18 est de l'ordre de 0,3 micromètre. Il en résulte que la distance e de la zone possible d'extension de charge d'espace, quand le drain 18 est soumis à une tension, est de l'ordre du micromètre. Cette distance est insuffisante pour permettre une tenue en tension drain/substrat supérieure à une valeur de l'ordre de 25 volts.

En conséquence, pour fabriquer des transistors MOS moyenne tension pouvant supporter entre leur drain et leur substrat des tensions de l'ordre de 25 à 50 volts, on a généralement recouru dans l'art antérieur à des technologies nettement distinctes de la technologie classique de fabrication de MOS basse tension illustrée dans les figures 1 à 3.

La figure 3B représente une vue en coupe selon la ligne B-B de la figure 1, c'est-à-dire une coupe selon la largeur de la zone de canal. On retrouve dans cette figure les mêmes références numériques que dans les figures précédentes. On notera le rôle de la zone dopée 14 sous la grille dite zone d'implantation de canal. Quand on réalise un circuit intégré comprenant plusieurs transistors MOS, on cherche généralement à obtenir des transistors MOS de différents types. Dans des transistors MOS dits naturels, aucune implantation 14 n'existe. Dans des transistors à appauvrissement ou déplétés, l'implantation de canal est du type opposé à celui du substrat pour fournir une couche 14 de type N très légèrement dopée (type N⁻) ; de tels transistor déplétés sont normalement conducteurs en l'absence de tension de grille. On peut également former des transistor à enrichissement ou transistors enrichis dans lesquels la zone 14 est plus fortement dopée que le substrat et du même type de conductivité que celui-ci de type P dans l'exemple de la figure. De tels transistors fonctionnent comme des transistors naturels mais ont des tension de seuil plus élevées.

Il est connu de brevet US-A-4577394 de prévoir un masque d'implantation de champ en débordement par rapport au masque antioxydation, mais alors le même traitment est appliqué à tous les transistors, qu'ils soient à enrichissement ou non.

Ainsi, étant donné une technologie classique et éprouvée de fabrication de transistors MOS basse tension telle que décrite précédemment, un objet de la présente invention est de prévoir un procédé de fabrication de transistor MOS moyenne tension comprenant des transistors à enrichissement impliquant un nombre minimum de modifications par rapport au procédé antérieur.

Un avantage recherché par la présente invention est de permettre d'utiliser un processus de fabrication existant et bien éprouvé pour lequel on connaît les fluctuations des paramètres et les mode de test pour réaliser pratiquement sans modification une structure de transistor MOS moyenne tension.

L'un des principaux avantages du procédé décrit est de pouvoir faire coexister sur une même puce des éléments prévus pour supporter une moyenne tension (ayant typiquement des dimensions élémentaires de l'ordre de plusieurs microns) et d'autres éléments prévus pour traiter des signaux logiques à faible tension (ayant typiquement des dimensions élémentaires de l'ordre du micron). L'invention permet, en utilisant les mêmes étapes principales de procédé de réaliser sur une même puce ces deux types d'éléments (transistors).

Ces objets sont atteints selon la présente invention par un procédé de fabrication d'un circuit intégré conforme aux revendications.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1, 2A à 2D, et 3A, 3B décrites ci-dessus représentent sous diverses vues et à diverses étapes de fabrication un transistor MOS basse tension selon l'art antérieur;

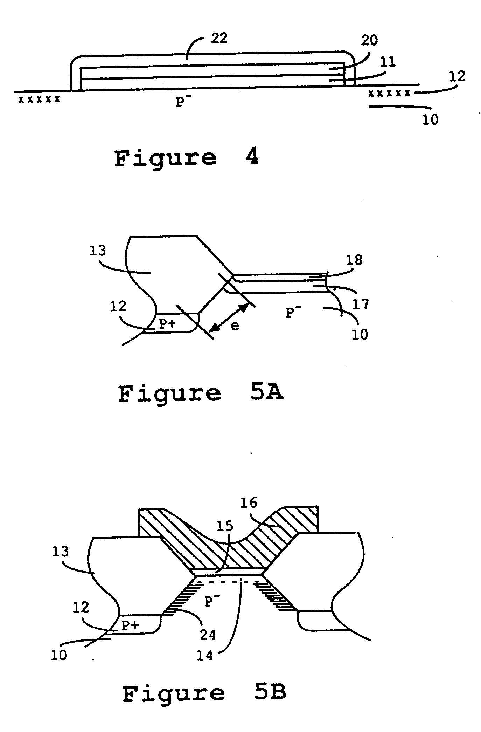

la figure 4 représente une vue en coupe longitudinale d'une étape de fabrication d'un transistor MOS moyenne tension comportant un masque d'implantation de champ en débordement par rapport au masque anti-oxydation ;
la figure 5A représente une vue en coupe d'un transistor MOS obtenu à la suite de la mise en oeuvre de l'étape décrite en relation avec la figure 4, à la limite entre une zone de drain et l'oxyde de champ, de façon analogue à la figure 3A ; et
la figure 5B représente une vue en coupe transverse de la zone de grille d'un transistor MOS obtenu à la suite de la mise en oeuvre de l'étape décrite en relation avec la figure 4, selon une représentation analogue à celle de la figure 3B.

Dans les diverses figures, de mêmes références désignent de même éléments ou de mêmes couches. En outre, de façon générale, et comme cela est habituel dans la représentation des circuits intégrés, on notera que les diverses figures ne sont pas représentées à l'échelle ni d'une figure à l'autre ni à l'intérieur d'une même figure et notamment que les épaisseurs, longueurs et largeurs des couches sont dessinées arbitrairement dans le but de faciliter la lecture des figures.

La figure 4 décrit une étape de base du procédé selon la présente invention, en partant du procédé de fabrication habituel, et après avoir obtenu comme cela est représenté en figure 2A un masque anti-oxydation 11 sur un substrat 10. Ce masque 11, couramment constitué d'une couche mince d'oxyde revêtue d'une couche de nitrure ou d' oxynitrure de silicium, a été formé par photolithogravure à partir d'un masque d'un produit photosensible tel qu'une résine 20. Selon l'invention, on n'enlève pas ce masque 20 mais au contraire on le soumet à un traitement de durcissement, par exemple en présence d'un rayonnement ultra-violet puis on dépose une couche de résine supplémentaire 22 qui est gravée par une seconde étape de photolithogravure de la façon représentée en figure 4, c'est-à-dire de façon à déborder par rapport au masque 11. On se sert ensuite des masques 11 et 22 comme masque de délimitation de l'implantation de champ 12.

Selon un avantage de ce procédé, toutes les autres étapes de fabrication, après enlèvement du masque 22 et de la couche de résine 20, sont identiques à celles utilisées classiquement dans le procédé de fabrication antérieur dont des étapes sont représentées schématiquement en figures 2B à 2D et ont été décrites précédemment.

Si l'on considère les figures 5A et 5B qui représentent des vues en coupe similaires à celles des figures 3A et 3B mais obtenues à la suite de la mise en oeuvre de l'étape selon l'invention décrite en relation avec la figure 4, on peut mieux voir les résultats obtenus grâce à cette mise en oeuvre. En se référant à la figure 5A, on voit que la distance d'extension de charge d'espace e entre la couche N⁺ de drain 18 et la couche P⁺ d'implantation de champ 12 est augmentée, cet agrandissement résultant du débordement entre les masques 11 et 22. Ainsi, on peut simplement passer à des valeurs de la distance e supérieures à 2 micromètres, selon la tension que l'on veut pouvoir supporter entre le drain et le substrat.

Cette augmentation de l'éloignement de la zone d'implantation de champ 12 par rapport à la pointe du bec d'oiseau de la couche d'oxyde de champ 13 se retrouve également dans la vue en coupe transversale de la zone de canal illustrée en figure 5B. On a plus particulièrement représenté dans cette figure, par la référence 24 et des hachures, la zone située sous le canal à la limite du bec d'oiseau entre l'implantation de canal 14 et l'implantation de champ 12. L'existence de cette zone de type P⁻ peut présenter un avantage ou un inconvénient selon les cas. En particulier, si le transistor MOS représenté est un transistor du type à enrichissement, c'est-à-dire que la diffusion 14 est un surdopage de type P, il pourra se produire au début de l'application d'une tension sur la grille 16 que la zone 24 s'appauvrisse avant la zone de canal 14 proprement dite, c'est-à-dire qu'il se peut que cette zone apparaisse comme une zone de type N avant la zone de canal et qu'il se produise donc des fuites entre le drain et la source pour une tension inférieure à la tension de seuil normale du transistor MOS.

Ainsi, selon la présente invention, il est prévu, lors de la formation du masque 22 au dessus du masque 11, de laisser déborder ce masque partout sauf dans les zones situées en vis-à-vis du canal des transistors enrichis à former. Ainsi, dans les zones de canal des transistors à enrichissement, on garde la structure illustrée en figure 3B. On notera d'ailleurs qu'il n'est généralement pas essentiel, mais seulement préférable pour éviter des défauts de fonctionnement d'adopter la procédure d'éloignement de la zone d'implantation de champ dans les zones de source qui, normalement, ne sont pas soumises à des tensions élevées. Mais il est néanmoins préférable de le faire car, lors de la fabrication des transistors MOS, l'attribution de la zone de drain par rapport à la zone de source n'est pas toujours fixée.

Des exemples ont été donnés dans le cadre d'un transistor MOS sur substrat P mais la présente invention pourrait s'appliquer à des transistors MOS sur substrat N en modifiant tous les types de conductivité. On notera d'ailleurs que dans les structures de type CMOS, il apparaîtra simultanément des transistors MOS sur substrat N et des transistors MOS sur substrat P.

## Revendications

1. Procédé de fabrication d'un circuit intégré comprenant des transistors MOS moyenne tensions parmi lesquels certains sont du type à enrichissement, comprenant les étapes suivantes :
- former sur un substrat semiconducteur (10) d'un premier type de conductivité un masque anti-oxydation (11) et délimiter ainsi la zone d'oxyde de champ (13) ainsi que les emplacements où seront formés des transistors MOS, ces emplacements comprenant des régions du substrat devant constituer les canaux des transistors à enrichissement ;
- former au dessus du premier masque (11) un deuxième masque(22) en débordement par rapport au premier masque (11) et délimiter ainsi la zone d'implantation de champ (12) ; le deuxième masque (22) n'étant pas formé en débordement par rapport au premier masque (11) en vis-à-vis des portions du pourtour du premier masque correspondant à la longueur desdits canaux.

2. Procédé selon la revendication 1, comprenant les étapes ultérieures suivantes :
- procéder à une implantation de champ du premier type de conductivité et former ainsi la zone d'implantation de champ (12) ;
- enlever le deuxième masque (22) ;
- procéder à une oxydation thermique et former ainsi les zones d'oxyde de champ (13) ; et
- procéder aux étapes de formation de grille (15, 16), de source (17, 18), de drain (17,18) et de contacts de source (6) et de drain (2) des transistors MOS.

3. Procédé selon la revendication 2, caractérisé en ce que le masque anti-oxydation (11) comprend une couche d'oxyde de silicium revêtue d'une couche de nitrure de silicium et que l' on a maintenu sur ledit masque (11) une couche de résine (20) qui a été durcie par traitment sous ultra-violets avant le dépôt du deuxième masque (22), ce deuxième masque (22) étant aussi constitué de résine.

4. Procédé selon l'une des revendications 2 ou 3, caractérisé en que les drains et sources des transistors MOS à effet de champ sont formés par deux étapes de dopage successives du deuxième type de conductivité, la deuxiéme étape de dopage entraînant l'obtention d'une haute concentration en impuretés dans les zones de surface (18) de source et de drain.

## Claims

1. A method for manufacturing an integrated circuit including medium voltage MOS transistors, some of which are of the enhancement type, including the following steps:
- forming over a semiconductor substrate (10) of a first conductivity type an anti-oxidation mask (11) in order to delimit the field oxide area (13) and the locations where MOS transistors are to be formed, said locations comprising substrate regions that are to constitute channels of enhancement transistors;
- forming over this first mask (11) a second mask (22) overflowing said first mask (11) and delimiting thereby the field implantation area (12); the second mask (22) not overflowing with respect to the first mask (11) in front of the portions of the periphery of the first mask corresponding to the length of said channels.

2. The method of claim 1, comprising the additional following steps:
- proceeding to a field implantation having the first conductivity type whereby the field implantation area (12) is formed;
- removing the second mask (22);
- performing a thermal oxidation whereby the field oxide areas (13) are formed; and
- carrying out the steps of forming the gate (15, 16), the source (17, 18), the drain (17, 18) and the source (6) and drain (2) contacts of MOS transistors.

3. The method of claim 2, characterized in that the anti-oxidation mask (11) comprises a silicon oxide layer coated with a silicon nitride layer and that one has maintained on said mask (11) a resin layer (20), which has been hardened by ultraviolet radiations before deposition of the second mask (22), this second mask (22) being also made of resin.

4. The method of claim 2 or 3, characterized in that the drains and sources of the field-effect MOS transistors are formed by two successive doping steps of the second conductivity type, the second doping step leading to the obtainment of a high impurity concentration in the source and drain surface areas (18).

## Patentansprüche

1. Verfahren zur Herstellung einer integrierten Schaltung mit MOS-Transistoren mittlerer Spannung, von denen einige vom Anreicherungstyp sind, mit folgenden Schritten:
- Bilden einer Antioxidationsmaske (11) auf einem Halbleitersubstrat (10) eines ersten Leitungstypes und damit Begrenzen der Feldoxidzone (13) und der Bereiche, auf denen MOS-Transistoren ausgebildet werden, wobei diese Bereiche Gebiete des Substrates enthalten, in denen die Kanäle der Transistoren vom Anreicherungstyp ausgebildet werden sollen;
- Ausbilden einer zweiten Maske (22) oberhalb der ersten Maske (11), wobei die zweite Maske über die erste Maske (12) herausragt, und damit Begrenzen der Feld-Implantationszone (12), wobei die zweite Maske (22) nicht über die erste Maske (11) gegenüber den Stellen am Umfang der ersten Maske herausragt, die der Länge der genannten Kanäle entsprechen.

2. Verfahren nach Anspruch 1, das zusätzlich die weiteren Schritte aufweist:
- Vornehmen einer Feldimplantation des ersten Leitungstyps und somit Bilden der Feld-Implantationszone (12);
- Entfernen der zweiten Maske (22);
- Vornehmen einer thermischen Oxidation und damit Bilden der Feldoxidzonen (13); und
- Vornehmen von Schritten zur Bildung eines Gitters (15, 16), einer Source (17, 18), einer Drain (17, 18) und von Kontakten für Source (6) und Drain (2) der MOS-Transistoren.

3. Verfahren nach Anspruch 2, dadurch gekennzeichnet, daß die Antioxidationsmaske (11) eine Schicht Siliciumoxid aufweist, die von einer Schicht aus Siliciumnitrid bedeckt ist, und daß auf dieser Maske (11) eine Harzschicht (20) aufgebracht ist, die durch eine Ultraviolettbehandlung vor dem Aufbringen der zweiten Maske (22) gehärtet worden ist, wobei diese zweite Maske (22) ebenfalls aus Harz gebildet ist.

4. Verfahren nach einem der Ansprüche 2 oder 3, dadurch gekennzeichnet, daß die Drainelektroden und Sourceelektroden der MOS-Feldeffekttransistoren durch zwei Schritte aufeinanderfolgender Dotierungen mit Material des zweiten Leitungstypes ausgebildet werden, wobei der zweite Dotierungsschritt eine hohe Konzentration von Verunreinigungen in den Oberflächenzonen (18) von Source und Drain nach sich zieht.
